# EUROPÄISCHE PATENTSCHRIFT

(11) **EP 2 764 327 B1**
(45) Veröffentlichungstag und Bekanntmachung des Hinweises auf die Patenterteilung: **18.01.2017**
(21) Anmeldenummer: 11784988.5
(22) Anmeldetag: 14.11.2011
(51) Int. Cl.: G01B 11/16, H01L 21/66

(54) **ERMITTLUNG VON FORMÄNDERUNGEN EINES SUBSTRATS**
DETERMINATION OF SUBSTRATE DEFORMATION
DÉTERMINATION DE LA DÉFORMATION D'UN SUBSTRAT

(43) Veröffentlichungstag der Anmeldung: 13.08.2014
(73) Patentinhaber: Ev Group E. Thallner GmbH, 4782 St. Florian am Inn (AT)
(72) Erfinder: WAGENLEITNER, Thomas, A-4971 Aurolzmünster (AT)
(74) Vertreter: Schweiger, Johannes
(86) Internationale Anmeldenummer: PCT/EP2011/070023
(87) Internationale Veröffentlichungsnummer: WO 2013/071943

(56) Entgegenhaltungen:
- WO-A1-01/20255
- WO-A2-00/38494
- DE-A1-102004 059 018
- US-A- 5 978 081
- US-A1- 2007 211 256
- US-A1- 2010 177 953

## Beschreibung

Die vorliegende Erfindung betrifft ein Verfahren zur Ermittlung von Formänderungen eines Substrats parallel zu dessen Substratoberfläche gemäß Patentanspruch 1.

Durch die immer weiter fortschreitende Miniaturisierung in der Halbleiterindustrie ist nicht mehr nur die Ausrichtung der Wafer zueinander, insbesondere in Hinblick auf die immer wichtiger werdende 3D-Technologie, von Bedeutung, sondern auch durch Behandlung der Wafer auftretende Formänderungen, insbesondere parallel zu der Waferoberfläche.

Vor allem in der Bondingtechnologie möchte man durch die stetig kleiner werdenden Strukturen eine möglichst hohe Ausrichtungs- und damit Bondinggenauigkeit erreichen. Das Problem der exakten Ausrichtung zweier Strukturen vor dem Bondprozess zueinander wird bereits durch unterschiedliche Techniken erfolgreich gelöst. Allerdings hat sich gezeigt, dass es während des Bondingvorgangs auch zu Verzerrungen der sich berührenden Strukturen zueinander kommen kann. Des Weiteren können sich Strukturen auf Grund anderer physikalischer Parameter relativ zueinander verschieben, nachdem ein Bondingprozess bereits durchgeführt wurde. Durch diese Verschiebungen beziehungsweise Verzerrungen kommt es zu einer erneuten oder verstärkten Abweichung der, vormals sehr guten, Ausrichtungsgenauigkeit, insbesondere nach einem bereits durchgeführten Bondingprozess. Der heutige Stand der Technik erfasst vor allem Messgeräte, die zwei Oberflächen bezüglich eines fix definierten Koordinatensystems abfahren, sich die Positionen der Strukturen auf der Oberfläche merken, und nach dem entsprechenden Bondvorgang die Messung wiederholen, um eine Aussage über die Verzerrungen zu erhalten. Die Messung einzelner Strukturen auf der Substratoberfläche vor und nach einer Behandlung des Substrats ist sehr aufwendig und mit entsprechenden Kosten verbunden.

Aufgabe der vorliegenden Erfindung ist es daher, ein Verfahren zur Ermittlung von Formänderungen eines Substrats parallel zu dessen Substratoberfläche vorzusehen, mit welchem die Ermittlung schnell, hochgenau, zuverlässig und kostengünstig erfolgt.

Diese Aufgabe wird mit den Merkmalen des Patentanspruchs 1 gelöst.

Der Grundgedanke der vorliegenden Erfindung ist es dabei, insbesondere mit einem mechanisch-optischen Messsystem, die relative Verschiebung zweier (oder mehrerer) Strukturen auf der Substratoberfläche zueinander (Abstand dxₙ/dyₙ) mittels einer erfindungsgemäßen Optik (zur Abbildung von zwei oder mehreren, auf einer Substratoberfläche verteilten Strukturen) und einem Erfassungsmittel zur Erfassung der abgebildeten Strukturen) zu ermitteln, die sich in zwei unterschiedlichen Sichtbereichen (field-of-view) von zwei (oder mehreren) Optikeinrichtungen der Optik befinden. Die vorliegende Erfindung verzichtet somit auf ein absolutes beziehungsweise fixes Bezugssystem für die Messung der relativen Verschiebung (Abstand dxₙ/dyₙ), so dass bei der erneuten Messung zur Feststellung von Formänderungen wieder die Relativposition zwischen den beiden (oder mehreren) zu erfassenden Strukturen ermittelt wird, um die, insbesondere durch die Bearbeitung des Substrats bewirkte, relative Verschiebung der zwei (oder mehreren) Strukturen ermitteln beziehungsweise auf die Formänderung des Substrats rückschließen zu können. Die erfindungsgemäße Ausführungsform nimmt daher, im Allgemeinen durch n-Optikeinrichtungen, im Speziellen durch nur zwei Optikeinrichtungen, die Oberflächen von n- beziehungsweise zwei unterschiedlichen Positionen gleichzeitig auf. Die Aufnahme ist eine Überlagerung aller n-beziehungsweise zwei Bilder. Die Aufnahme erfolgt insbesondere durch CCD-Detektoren, analoge Kameras etc.

Als erfindungsgemäße Strukturen sind insbesondere Erfassungsmarken, aber auch geprägte Strukturen oder Teile davon denkbar. Bei geprägten Strukturen sind Teile der - insbesondere im step-and-repeat-Verfahren - jeweils geprägten Prägestrukturen oder die jeweilige Prägestruktur oder zusammengefasst mehrere Prägestrukturen denkbar.

Ein Abstand A zwischen der Optik oder den Optikeinrichtungen (insbesondere deren Linsen) und der Oberfläche des zu messenden Substrats hängt von den Eigenschaften der verwendeten Linse(n) ab. Dem Fachmann ist der Abstand unterm dem Begriff "working distance", respektive Arbeitsabstand, bekannt. Die erfindungsgemäße Ausführungsform weist einen Arbeitsabstand im Mikrometerbereich auf. Andere Dimensionen sind ebenfalls möglich. Die "depth-of-focus" (DOF) Variation beträgt ca. 5-50µm. Bei einer 20fachen Vergrößerungsstufe sollte die DOF Variation kleiner als 10µm, bei einer 10fachen Vergrößerungsstufe sollte die DOF Variation kleiner als 20µm, bei einer 5fachen Vergrößerungsstufe sollte die DOF Variation kleiner als 50µm sein.

Im weiteren Verlauf werden die Termini "tatsächlicher Abstand" (Abstand B) und "virtueller Abstand" (Abstand dxₙ/dyₙ) definiert. Unter tatsächlichem Abstand versteht man im Zuge dieser Erfindung den realen Abstand zwischen zwei Strukturen, so wie er durch jede beliebige andere Messmethode ermittelt werden würde. Unter virtuellem Abstand verstehen wir den Abstand (dxₙ/dyₙ) zwischen zwei Strukturen im Erfassungsfeld (Kameraraum). Der virtuelle Abstand ist abhängig von den X-Y-Positionen der beiden (oder mehreren) Optikeinrichtungen zueinander, jedoch unabhängig von den X-Y-Positionen der Optikeinrichtungen zu dem zu messenden Substrat (Probenkoordinatensystem, siehe unten). Somit deckt sich das erfindungsgemäße Erfassungsfeld nicht zwingend mit einem mindestens eine Struktur aufweisenden Strukturfeld. Ein Strukturfeld kann insbesondere eine im step-and-repeat-Verfahren aufgebrachte Prägestruktur sein. Für jedes Strukturfeld können mehrere Erfassungsfelder vorgesehen sein und umgekehrt.

Die erfindungsgemäße Ausführungsform wird für eine Vorher-/Nachermessung verwendet. Genauso wichtig ist die Verwendung der erfindungsgemäßen Optik für eine Bestimmung der relativen Abstände von Oberflächenstrukturen in einem einzelnen, insbesondere gleichzeitigen, Messprozess, um eine statistische Aussage über die relativen Abstände der Strukturen an dieser einen Oberfläche zu erhalten. Dadurch erhält man bereits vor einem allfälligen Bondvorgang eine statistische Aussage über die Abstände zwischen den Strukturen. Drittens ist eine in-situ Messung während der Verformung der Oberfläche, also beispielsweise während eines Bondvorgangs, denkbar.

Erfindungsgemäß existieren mehrere erwähnenswerte Koordinatensysteme. Das auf die Optik bezogene Optikkoordinatensystem, das Probenkoordinatensystem, welches mit dem zu messenden Substrat verbunden beziehungsweise zu diesem oder der Substrataufnahme fix ist und das Laborkoordinatensystem, in welchem die erfindungsgemäße Vorrichtung verortet ist.

Mit einer erfindungsgemäßen Ausführungsform ist es denkbar, den Tool-Induced-Shift (TIS) zu berechnen. Der TIS ist dem Fachmann bekannt. Es handelt sich dabei um eine Abweichung einer Struktur von der idealen, erwarteten Lage, auf Grund von Werkzeug- und Optikfehlern. Beispielsweise muss die optische Achse beziehungsweise die optischen Achsen) nicht immer normal auf die zu messende Oberfläche stehen. Um zu berechnen, wie groß der Fehler der optischen Achse bezogen auf die Substratoberfläche ist, wird die X-Y-Position der Struktur erfindungsgemäß in einer Rotationslage von 0° bestimmt. Danach wird das gesamte System um 180° gedreht und erneut die X-Y-Position der Struktur an der Oberfläche bestimmt. Der TIS ist der arithmetische Mittelwert der bei 0° und 180° ermittelten X-Y-Positionen zweier beliebiger Strukturen. Der TIS muss im Idealfall nur einmal pro Gerät bestimmt werden. Praktisch wird die TIS Berechnung nach dem Wechsel eines jeden Wafers (Substrat) durchgeführt. Der TIS Wert ist topographieabhängig. Je höher die Topographie, desto größer wird der TIS. Diese Abhängigkeiten und die daraus resultierenden technischen Probleme sind dem Fachmann ebenfalls bekannt.

Die erfindungsgemäße Vorrichtung eignet sich vor allem dazu, die relative Verschiebung beziehungsweise den "virtuellen Abstand" zweier (oder mehrerer) weit entfernter Punkte auf einem Wafer mittels mehrerer starr miteinander verbundener Optikeinrichtungen ohne Zuhilfenahme eines fixen Bezugssystems zu ermitteln. Soll ein tatsächlicher Abstand B in X-und/oder Y-Richtung zusätzlich oder statt einer Verschiebung bestimmt werden, kann die Optik vorher mit einem Kalibrierungswafer kalibriert werden. Am Kalibrierwafer befinden sich als Strukturen mehrere Marken, mindestens aber zwei Marken, von denen der Abstand zueinander mit hoher Genauigkeit bekannt ist. Solche Wafer können beispielsweise durch Verfahren mit hoher Ortsauflösung, beispielsweise einem Elektronenstrahlschreibverfahren hergestellt werden.

Die Optikeinrichtungen werden anhand dieser beiden Marken ausgerichtet und in Ihrer Position fixiert. Danach kann die erfindungsgemäße Ausführung Punkte, welche sich in ähnlichen Abständen befinden, durch Bildüberlagerung exakt vermessen. Erfindungsgemäß ist des entscheidend, dass sich die Optikeinrichtungen der Optik nach der Kalibrierung und/oder zwischen Messungen am selben Substrat nicht mehr zueinander verschieben. Mittels des Kalibrierwafers ist die erfindungsgemäße Ausführungsform zur Ermittlung eines Rotationsfehlers zwischen Probenhalter und Optik verwendbar. Dazu werden zwei (bei einer n-fach Optik entsprechend n) Messpunkte mit genau bekanntem Abstand fokussiert. Die Optikeinrichtungen befinden sich dabei mit Vorteil konzentrisch um die Drehachse des Probenhalters oder linear zueinander. Bei n-Optikeinrichtungen beträgt der Winkel zwischen jeweils zwei Optikeinrichtungen 360/n Grad. Es erfolgt eine Aufnahme (Erfassung) von n-Strukturen in der Drehposition 0 Grad. Danach wird der Wafer um 360/n Grad gedreht. Es erfolgt eine weitere Aufnahme. Es ergeben sich damit im optimalen Fall n Aufnahmen. Aus den n Aufnahmen ist die Schrägstellung der Probenhalteroberfläche ermittelbar.

Es sei nochmals explizit hervorgehoben, dass zur Verzerrungsbestimmung durch einen Vorher-/Nachher-Vergleich keine Kalibrierung der erfindungsgemäßen Optik nötig ist. Die Kombination beider Methoden wird hiermit ebenfalls offenbart.

Aus den offenbarten Möglichkeiten können erfindungsgemäß mit Hilfe von Vektorrechnung und/oder statistischer Verfahren alle nötigen Informationen über Positionen, Verzerrungen und Verschiebungen von Strukturen auf Substratoberflächen (also insbesondere in X- und/oder Y-Richtung, vorzugsweise einer Substratoberflächenebene) vor, während und nach einem beliebigen Prozess, im Speziellen einem Bondprozess, ermittelt und/oder berechnet werden.

Alle vor einem Bondingprozess erhaltenen Daten können, insbesondere über eine Datenleitung und ein entsprechendes Frequenzband an ein zweites Gerät, beispielsweise einen Bonder, übertragen werden. Mit Vorzug wird eine solche Weiterleitung innerhalb einer in-line Prozesskette erfolgen, in welcher mehrere Geräte mit unterschiedlichen Aufgaben ein Wafersystem sequentiell behandeln sollen.

Formänderungen können dabei entlang der Substratoberfläche auftretende Dehnungen und/oder Verzerrungen sein, die beispielsweise durch eine Wärmebehandlung des Wafers, insbesondere auf einer von der erfindungsgemäßen Vorrichtung getrennten Einrichtung, verursacht worden sind. Die erfindungsgemäß relevanten Formänderungen liegen unter 1000 nm, insbesondere unter 500 nm, noch besser unter 200 nm, vorzugsweise unter 100 nm, noch bevorzugter unter 50 nm.

Das Verfahren wird vorzugsweise, aber nicht einschränkend nur, bei noch nicht rückgedünnten Wafern angewandt. Diese Wafer haben genormte Standarddicken. Als Substrat kommen daher beispielsweise Wafer in Frage, insbesondere mit einer Dicke kleiner 1000 µm, vorzugsweise kleiner 800 µm, noch bevorzugter kleiner 725 µm. Typische Durchmesser von Wafern sind 200 mm, 300 mm oder 450 mm. Das Verfahren ist, streng genommen, unabhängig von der Waferdicke. Indem die erfindungsgemäße Optik allerdings vorwiegend auf dickere, noch nicht rückgedünnte Wafer angewandt wird, können schlecht zueinander verbondete Wafer in einem späteren Rework Prozess wieder voneinander getrennt werden. Das Trennen, also der "Rework", schlecht miteinander verbondeter Wafer ist besonders vor einem später stattfindenden Wärmebehandlungsschritt sinnvoll. Nach einem solchen hat sich meist eine derart starke Permanentverbindung zwischen den beiden Wafern hergestellt, dass sie mit keiner Methode mehr voneinander getrennt werden können. Das Verfahren ist nicht auf ein bestimmtes Wafermaterial beschränkt. Es können daher alle Arten von Wafern, aus den unterschiedlichsten Materialien verwendet werden. In der Halbleiterindustrie werden vorwiegend Wafer aus Halbleitermaterialien verwendet. Denkbar sind auch Materialien aus Keramiken, Metallen oder Kunststoffen wie insbesondere:
- Si, Ge, GeAs, InP, etc...
- Cu, Au, Ag, Ti, Cr, etc...
- Polymere
- Keramiken
- Verbundwerkstoffe

Als erfindungsgemäße Strukturen kommen insbesondere Ausrichtungsmarkierungen, elektronische Bauteile auf dem Wafer, Dices, IC-Strukturen und Kanten in Frage. Dabei sind die Strukturen vorzugsweise unterschiedlich, noch bevorzugter komplementär zueinander ausgebildet.

Die erfindungsgemäße Erfassungseinrichtung zur Erfassung des Abstands kann die Positionen der vorgenannten Strukturen relativ zueinander erfassen und zuordnen, insbesondere nach einer Fokussierung der jeweiligen Optikeinrichtung auf die entsprechende Struktur.

Erfindungsgemäße Bestandteile der Optikeinrichtungen können insbesondere Prismen, Spiegel (Umlenkmittel) und/oder Linsen sein. Die Prismen sind in vorteilhafter Weise als Reflexionsprismen und/oder Polarisationsprismen ausgebildet. Die Linsen haben einen Vergrößerungsfaktor größer 1, insbesondere größer als 2, vorzugsweise größer als 5, noch bevorzugter größer als 10, noch bevorzugter größer als 100, mit allergrößtem Vorzug größer als 1000. Die Linsen sind dabei so ausgebildet, dass ein möglichst geringer Abstand zwischen den Linsen der jeweiligen Optikeinrichtung und dem jeweiligen Substrat beziehungsweise der jeweiligen zu erfassenden Struktur realisierbar ist. Soweit von Strahlengängen die Rede ist, können erfindungsgemäß auch Strahlengangabschnitte gemeint sein. Spiegel dienen zur Ablenkung/Ausrichtung von Strahlengängen. Die Position und/oder Ausrichtung der vorgenannten Bestandteile der Optiken sind innerhalb der Optik (also bezogen auf das Optikkoordinatensystem) fixierbar.

Ein Aspekt der Erfindung besteht auch darin, dass, insbesondere durch Überlagerung oder Zusammenführung der Strahlengänge der beiden Optikeinrichtungen nicht zwingend ein reeller Abstand zwischen den Strukturen gemessen wird, sondern ein imaginärer oder durch die Optikeinrichtungen projizierter Abstand, da es erfindungsgemäß lediglich auf die genaue Ermittlung der Abstandsänderung ankommt.

Gemäß einer vorteilhaften Ausführungsform ist vorgesehen, dass die Vorrichtung Kalibriermittel zur Kalibrierung der ersten und zweiten Optikeinrichtungen (oder mehrerer Optikeinrichtungen) relativ zueinander aufweist. Somit ist die erfindungsgemäße Vorrichtung auf unterschiedliche Substrate und Strukturabstände einstellbar.

Soweit der erste und/oder der zweite Strahlengang (oder entsprechend mehrere Strahlengänge) verstellbar ausgebildet ist/sind, ist die erfindungsgemäße Vorrichtung flexibler einsetzbar, insbesondere für unterschiedliche Substrate oder Substrattypen mit unterschiedlichen Strukturen auf den Substraten. Hierbei ist es von Vorteil, wenn die Verstellung des Strahlengangs durch Verstellung von Linsen der jeweiligen Optikeinrichtung, insbesondere einer einzigen Linse pro Optikeinrichtung, erfolgt. Dabei sind vorzugsweise 6 Freiheitsgrade, 3 Freiheitsgrade der Translation und 3 Freiheitsgrade der Rotation, vorgesehen.

Der erste und der zweite Strahlengang sind relativ zueinander fixierbar ausgebildet, so dass zwischen zwei Messungen der Abstände der ersten und zweiten Strukturen keine Verstellung möglich ist, und eine größtmögliche Genauigkeit bei der Ermittlung der Abstandsänderung gegeben ist.

Gemäß einem weiteren Aspekt ist es vorgesehen, dass eine, insbesondere schwingungsgedämpfte und/oder thermisch isolierte, Aufnahmeeinrichtung zur Aufnahme und gemeinsamen Bewegung der ersten und zweiten (oder weiterer) Optikeinrichtungen relativ zum Substrat vorgesehen ist. Auf diese Weise bleiben die Optikeinrichtungen trotz relativ zueinander (also im Optikkoordinatensystem) erfolgter Fixierung beweglich.

Es ist weiterhin mit Vorteil vorgesehen, dass die Erfassungseinrichtung eine einzige, insbesondere digitale, Kamera aufweist, mit der die erste und zweite Struktur über die erste und zweite Optikeinrichtung, insbesondere gemeinsam, vorzugsweise gleichzeitig, erfassbar sind. Die Erfassungseinrichtung erhält einen digitalen oder digitalisierten Wert für die Position der ersten und für die Position der zweiten Struktur und ermittelt daraus einen Abstand zwischen den beiden Strukturen, insbesondere separat in X-Richtung und in Y-Richtung, also ein dx₁ und ein dy₁.

Soweit der erste und zweite Strahlengang, insbesondere durch Umlenkmittel der ersten und/oder zweiten Optikeinrichtung, so ausrichtbar sind, dass sie zur Erfassung des Abstands durch die Erfassungsmittel zusammenlaufen, ist eine gleichzeitige Erfassung der ersten und zweiten Struktur bei größtmöglicher Auflösung trotz großen Abstands zwischen den beiden Strukturen (also größer als der Erfassungsbereich jeder einzelnen Optikeinrichtung) möglich.

Gemäß einer weiteren, vorteilhaften Ausführungsform st vorgesehen, dass durch die Vorrichtung eine Vielzahl von Abständen von entlang der Substratoberfläche verteilten Erfassungspaaren (jeweils mit ersten und zweiten Strukturen) erfassbar und dem jeweiligen Erfassungspaar zuordenbar ist. Auf diese Weise lassen sich nicht nur einzelne Formänderungen am Substrat feststellen, sondern Formänderungskarten in Form von Änderungsvektoren, also Spannungs- und/oder Dehnungskarten zum jeweiligen Substrat ermitteln, die für die weitere Prozessierung des Substrats verwendet werden können.

Die Materialien der Teile der erfindungsgemäßen Ausführungsform sind möglichst unempfindlich gegenüber thermischer Beanspruchung. Im speziellen besitzen sie einen thermischen Ausdehnungskoeffizient nahe Null, im besten Fall einen thermischen Ausdehnungskoeffizienten von Null. Erwähnt sei in diesem Zusammenhang die Verwendung der Invar™ Legierung.

Die Anwendungsmöglichkeiten der erfindungsgemäßen Optik sind vielfältig. Denkbar ist die Vermessung der Strukturen einer Oberfläche vor und nach einem Bondvorgang. Dabei wird die erfindungsgemäße Optik mit einer Quelle kombiniert, deren elektromagnetische Strahlungen die zu untersuchenden Wafer durchdringen können. Durch eine Vermessung von Strukturen vor und nach dem Bonden, im optimalsten Fall die Vermessung zweier Strukturen während des Bondvorgangs, also in-situ, kann eine die Verschiebung der Strukturen zueinander, also die Verzerrung gemessen werden. Der Grund für eine solche Messung liegt in der von der Halbleiterindustrie immer weiter forcierten und verlangten Ausrichtungsgenauigkeit. Diese wird umso wichtiger, je kleiner die miteinander zu verbondenden Strukturen werden. Stellt man nach einem solchen Bondvorgang fest, dass die Verzerrungen zu groß sind, können die Wafer wieder voneinander getrennt und neu verwendet werden.

Gemäß einer vorteilhaften Ausführungsform ist zwischen der Substratoberfläche und der/den Optikeinrichtung(en) ein, insbesondere flüssiges, Fluid zur Änderung des Brechungsindex während der Erfassung einbringbar.

In alle optischen Wege können unterschiedliche Filter eingebaut werden. In einer bevorzugten Ausführungsform werden Halbschattenfilter und/oder Polarisationsfilter verwendet. Des Weiteren können Filter zur vollständigen Unterbrechung- des optischen Weges eingebaut werden, um eine leichtere Identifizierung der Strukturen im Bildraum (beziehungsweise im überlagerten Bild in der Erfassungseinrichtung) durch sequenzielles Einund Ausschalten einzelner Strahlengänge zu erhalten. Es sind auch alle anderen dem Fachmann bekannten Filter, die zweckdienliche Eigenschaften erfüllen, denkbar.

Soweit vorrichtungsgemäße Merkmale Verfahrensmerkmale implizieren oder beschreiben, sollen diese als verfahrensgemäß offenbart gelten und umgekehrt.

Weitere Vorteile, Merkmale und Ausführungsformen der vorliegenden Erfindung ergeben sich aus der nachfolgenden Figurenbeschreibung sowie den Patentansprüchen und den zugehörigen Figuren. Diese zeigen in:
- Figur 1a: eine Aufsicht auf ein Substrat mit Erfassungsfeldern,
- Figur 1b: eine Detailansicht eines aus zwei Erfassungsfeldern bestehenden Erfassungspaares mit Strukturen,
- Figur 2a: eine schematische Querschnittsansicht einer erfindungsgemäßen Vorrichtung bei der Erfassung eines ersten Abstands zwischen einer Abbildung einer ersten Struktur und einer Abbildung einer zweiten Struktur,
- Figur 2b: eine schematische Ansicht eines von der Erfassungseinrichtung erfassten Bildes (mit den Abbildungen gemäß Figur 2a) zur Auswertung und Ermittlung von Abständen der Abbildungen gemäß Figur 2a in einer ersten Ausführungsform der Erfindung,
- Figur 3a: eine schematische Querschnittsansicht einer erfindungsgemäßen Vorrichtung bei der Erfassung eines zweiten Abstands zwischen der Abbildung der ersten Struktur und der Abbildung der zweiten Struktur nach einem Behandlungsschritt,
- Figur 3b: eine schematische Ansicht eines von der Erfassungseinrichtung erfassten Bildes (mit den Abbildungen gemäß Figur 3a) zur Auswertung und Ermittlung von Abständen der Abbildungen gemäß Figur 3a,
- Figur 4a: eine schematische Querschnittsansicht einer zweiten Ausführungsform der Erfindung mit drei Optikeinrichtungen,
- Figur 4b: eine schematische Ansicht eines von der Erfassungseinrichtung erfassten Bildes (mit den Abbildungen gemäß Figur 4a) zur Auswertung und Ermittlung von Abständen der Abbildungen gemäß Figur 4a,
- Figur 5: eine schematische Querschnittsansicht einer dritten Ausführungsform der Erfindung mit zwei Optikeinrichtungen und Filtereinrichtungen und
- Figur 6: eine schematische Perspektivansicht einer vierten Ausführungsform der Erfindung mit hintereinandergeschalteten Optiken.

In den Figuren sind gleiche oder gleichwirkende Bauteile mit den gleichen Bezugszeichen gekennzeichnet.

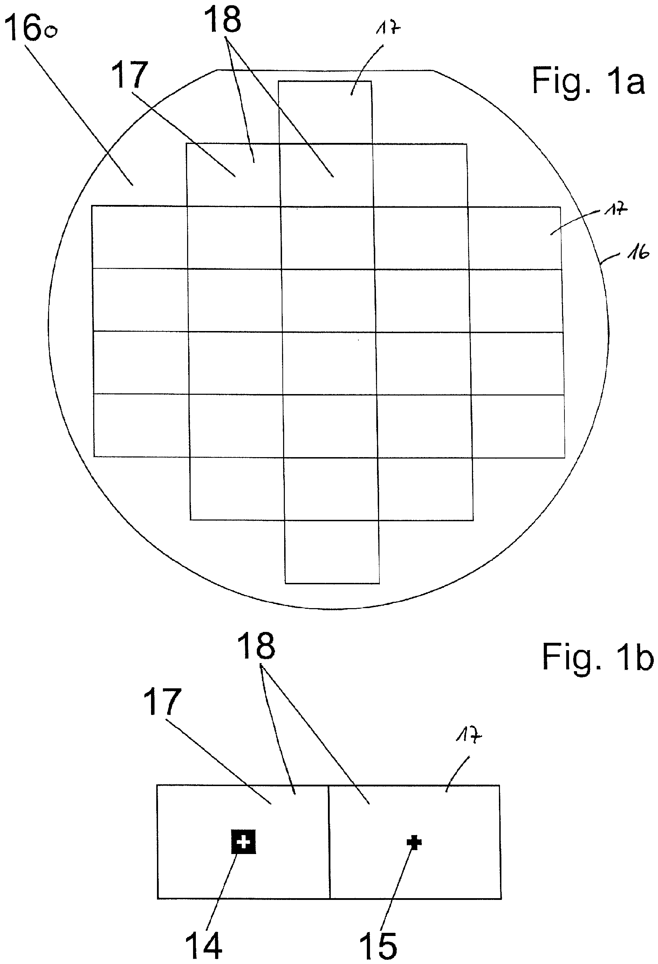

Figur 1a zeigt eine Aufsicht auf eine Substratoberfläche 16o eines Substrats 16 mit einer Vielzahl von Erfassungsfeldern 17, wovon zwei Erfassungsfelder 17 ein Erfassungspaar 18 bilden. Erfassungspaare 18 können dabei zwei (oder mehrere) beliebige Erfassungsfelder 17 sein, vorzugsweise jedoch benachbarte Erfassungsfelder 17. Auf jedem Erfassungsfeld 17 des Erfassungspaares 18 ist gemäß Figur 1b jeweils mindestens eine Struktur 14, 15 vorgesehen. Auf dem linken Erfassungsfeld 17 gemäß Figur 1b ist eine erste Struktur 14 und auf dem rechten eine zweite Struktur 15 vorgesehen. Die erste Struktur 14 ist erfindungsgemäß unterschiedlich, insbesondere komplementär, zur zweiten Struktur 15 dargestellt, damit eine Unterscheidung/Identifizierung der Strukturen 14, 15 einfacher möglich ist. Die Strukturen 14, 15 können aber auch gleiche Form und/oder Größe besitzen, also deckungsgleich sein.

Je mehr Erfassungsfelder 17 beziehungsweise Erfassungspaare 18 mit einer oder mehreren Strukturen 14, 15 auf einer Substratoberfläche 16o des Substrats 16 verteilt sind, desto genauer können Formänderungen des Substrats entlang beziehungsweise parallel zur Substratoberfläche 16o festgestellt werden.

Die Erfassungsfelder 17 könnten insbesondere Dicing Sheets sein, wobei Referenzmarken der Dicing Sheets gleichzeitig als Strukturen 14, 15 dienen würden. Dabei handelt es sich um Bereiche, die in einem späteren Back-End Prozess durch Trennmittel voneinander separiert werden.

Die schematische Darstellung in den Figuren ist nicht maßstabsgetreu, damit die Funktion der erfindungsgemäßen Bestandteile der Vorrichtung einfacher erfasst werden kann. Aus diesem Grund sind für die Beschreibung der Erfindung weniger oder nicht relevante Bauteile oder Bauteile, deren Funktion bekannt ist, in den Figuren nicht dargestellt. So ist beispielsweise keine Substrataufnahme dargestellt, da hier auf bekannte Substrataufnahmen (Chucks) zurückgegriffen werden kann. Weiterhin ist kein Gestell beziehungsweise Gehäuse für die Vorrichtung dargestellt, da auch hier auf bekannte Gestelle zurückgegriffen werden kann, insbesondere in Verbindung mit einem Roboterarm zur Halterung und Positionierung einer Optik 1 mit einer Aufnahmeeinrichtung 3 zur Aufnahme und gemeinsamen Bewegung einer ersten Optikeinrichtung 4 und einer zweiten Optikeinrichtung 7 relativ zum Substrat 16, insbesondere parallel zur Substratoberfläche 16o. Zur Aufnahmeeinrichtung 3 kann insbesondere ein Roboterarm gehören.

Die erste Optikeinrichtung 4 ist mit einer Linse 6 und einem Prisma 5 ausgestattet, wobei die Linse 6 in Richtung und mit einer Stirnseite 4s nahezu (Abstand A) der ersten Struktur 14 ausrichtbar ist, damit das die erste Struktur 14 enthaltende Erfassungsfeld 17 zumindest teilweise von einem Strahlengang 12 der ersten Optikeinrichtung 4 in deren Erfassungsbereich 19 erfassbar ist (field of view). Der Strahlengang 12 verläuft durch die, insbesondere als Sammellinse ausgebildete, Linse 6, die zur Vergrößerung und Parallelisierung der auf der Linse 6 von der Substratoberfläche 16o eintreffenden, nicht parallelen Lichtwellen dient.

Die erste Optikeinrichtung 4 ist durch eine nicht dargestellte Steuerungseinrichtung der Vorrichtung auf die erste Struktur 14 fokussierbar.

Als Prisma 5 und/oder 8 kommt insbesondere ein, vorzugsweise zumindest teilweise, noch bevorzugter an seiner Schrägfläche 5s und/oder 8s, amorphes, Glasprisma in Frage. Dieses lässt an seiner Schrägfläche 5s, 8s von einer Lichtquelle erzeugte und von den Strukturen 14, 15 reflektierte Lichtwellen zumindest teilweise reflektieren. Hierdurch werden die von der Struktur 15 reflektierten Lichtwellen (Strahlengang 13) zunächst an der Schrägfläche 8s in den Strahlengang 11 umgelenkt (durch zumindest teilweise Reflexion). Die Lichtwellen des Strahlengangs 11 werden an der Schrägfläche 5s zumindest teilweise zu dem Strahlengang 10 umgelenkt/reflektiert.

Die Lichtquelle kann sich in der Erfassungseinrichtung 2, neben der erfindungsgemäßen Ausführungsform oder unter dem zu messenden Substrat befinden. Im zweiten Fall, wird das Licht also seitlich eingestrahlt, im dritten Fall muss das zu vermessende Substrat transparent im entsprechenden Wellenlängenbereich der Lichtquelle sein.

Gleichzeitig treten die von der Struktur 14 reflektierten Lichtwellen (Strahlengang 12) an der Schrägfläche 5s (Reflexionsfläche) in den Strahlengang 10 über, wobei eine möglichst geringe, vorzugsweise keine, Umlenkung erfolgt.

Somit bildet die erste Optikeinrichtung 4 das die Struktur 14 umfassende field of view an der Erfassungseinrichtung 2 ab, wobei die Struktur 14 als Abbildung 14' von der Erfassungseinrichtung 2 erfassbar ist.

Die Lichtquelle (nicht dargestellt) kann als Reflexionslichtquelle, insbesondere Streulicht erzeugend, ausgebildet sein. Alternativ kann auch eine durch das Substrat 16 transmittierende Lichtquelle vorgesehen sein. Die Lichtquelle kann insbesondere der Kamera (Erfassungseinrichtung 2) zugeordnet sein.

Die zweite Optikeinrichtung 7 ist analog zur ersten Optikeinrichtung 4 mit einem Prisma 8 und einer Linse 9 versehen und ein Strahlengang 13 der zweiten Optikeinrichtung 7 ist so anordenbar, dass die zweite Struktur 15 beziehungsweise das die zweite Struktur 15 aufweisende Erfassungsfeld 17 oder ein Erfassungsbereich (field of view) hiervon erfassbar ist.

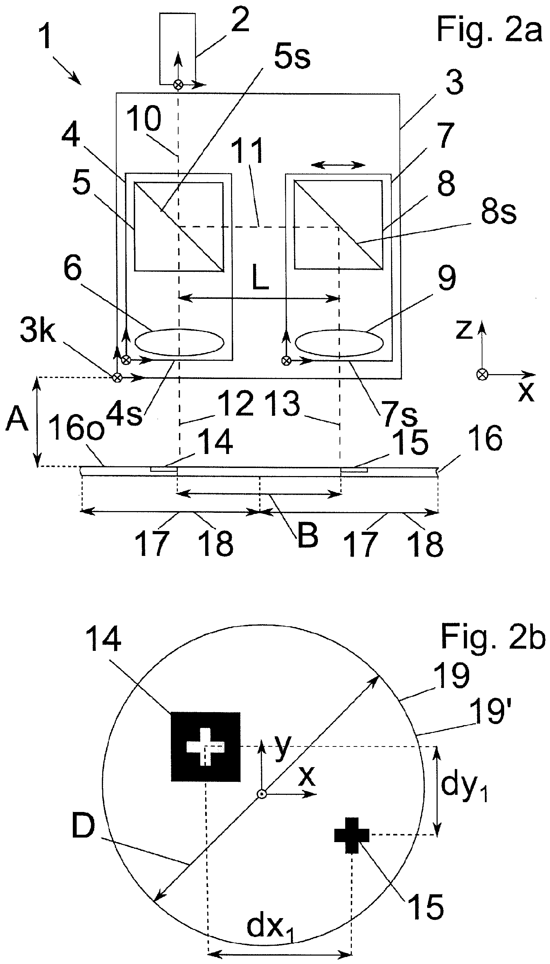

Das in der zweiten Optikeinrichtung 7 vorgesehene Prisma 8 lenkt den Strahlengang 13 in einen umgelenkten Strahlengang 11 in Richtung des Prismas 5 der ersten Optikeinrichtung ab, wo der Strahlengang 11 mit dem Strahlengang 12 zu einem gemeinsamen Strahlengang 10 zusammengeführt wird und auf eine Erfassungseinrichtung 2 in Form einer vorzugsweise digitalen Kamera mit einem hochauflösenden Bildsensor trifft. Die Erfassungseinrichtung 2 erfasst ein in der Figur 2b dargestelltes Bild, das gleichzeitig die vergrößerte Abbildung 14' der ersten Struktur 14 und eine, insbesondere entsprechend, vergrößerte Abbildung 15' der zweiten Struktur 15 enthält.

Das Prisma 8 in Fig. 2a kann auch durch einen Spiegel ersetzt werden, da es in der dort dargestellten Ausführungsform keines weiteren transmittierten Strahlengangs bedarf.

Eine Ausrichtung der ersten Optikeinrichtung 4 zur ersten Struktur 14 und eine Ausrichtung der zweiten Optikeinrichtung 7 zur zweiten Struktur 15 ist nur insoweit nötig, dass die Strukturen 14, 15 vollständig von der jeweiligen Optikeinrichtung 4, 7 erfasst werden (im Erfassungsbereich beziehungsweise field of view). Die Ausrichtung erfolgt vorzugsweise durch Bewegung des Substrats 16 (beziehungsweise der das Substrat 16 aufnehmenden Substrataufnahme), während die Optikeinrichtungen 4, 7 während der Ausrichtung fix sind. Erfindungsgemäß ist es denkbar, die Ausrichtung der verschiedenen Richtungen (X, Y, Z und ggf. Rotation) zwischen den Optikeinrichtungen 4, 7 und der Substrataufnahme aufzuteilen. Auf eine exakte Ausrichtung der Optikeinrichtung 4, 7 gegenüber den Strukturen 14, 15 zur Feststellung der absoluten Position der Strukturen 14, 15 kann verzichtet werden, worin ein wesentlicher Vorteil der vorliegenden Erfindung besteht.

Das von der Erfassungseinrichtung 2 erfasste, überlagerte Bild der beiden Erfassungsbereiche der Optikeinrichtungen 4 und 7 mit Abbildungen 14', 15' gemäß Figur 2b ist derart auswertbar, dass ein Abstand dx₁ der Abbildung 14' der ersten Struktur 14 zur Abbildung 15' der zweiten Struktur 15 in einer X-Richtung ermittelbar ist. Ebenso ist ein Abstand dy₁ in einer orthogonal zur X-Richtung verlaufenden Y-Richtung (beide parallel zur Substratoberfläche 16o) ermittelbar. Die Abstände dx₁ und dy₁ entsprechen, im Allgemeinen, nicht den tatsächlichen Abständen der Strukturen 14, 15 auf der Substratoberfläche 16o.

Optional kann über eine vorherige Kalibrierung der ersten und zweiten Optikeinrichtungen 4, 7 zueinander der tatsächliche Abstand B zwischen den Strukturen 14, 15 berechnet werden, indem die optischen Parameter, insbesondere die Länge L des umgelenkten Strahlengangs 11, bestimmt/ermittelt werden. Die Länge L ist mit Vorzug dreimal, mit größerem Vorzug fünfmal, mit noch größerem Vorzug zehnmal, mit größtem Vorzug fünfzehnmal größer als die Länge und/oder Breite des field-of-view Bereiches.

Soweit in Y-Richtung keine Umlenkung der Strahlengänge 12, 13 erfolgt und der Strahlengang 13 exakt parallel kalibriert worden ist beziehungsweise ausgerichtet worden ist, entspricht der Abstand dy₁ - abgesehen von einer etwaigen Vergrößerung durch die Linse 9 - dem tatsächlichen Abstand beziehungsweise Versatz der Strukturen 14, 15 in Y-Richtung. Dies ist aber wegen der relativen Ermittlung der Abstände dxₙ, dyₙ erfindungsgemäß nicht notwendig, so dass die Ausrichtung der Optikeinrichtungen 4, 7 erfindungsgemäß nur grob erfolgen muss, um die Strukturen innerhalb des Erfassungsraums der Optikeinrichtungen 4, 7 zu haben und fokussieren (zur Erfassung) zu können.

Für die Kalibrierung beziehungsweise Einstellung der Optikeinrichtungen 4, 7 ist zumindest die zweite Optikeinrichtung 7 in X- und Y-Richtung verfahrbar, damit die Optikeinrichtung 4, 7 relativ zueinander so positionierbar sind, dass die Strukturen 14, 15 im jeweiligen Strahlengang 12, 13 liegen und erfassbar sind. Die zweite Optikeinrichtung 7 wird dabei relativ zu der Aufnahmeeinrichtung 3 bewegt, während die erste Optikeinrichtung 4 relativ zur Aufnahmeeinrichtung 3 fixiert ist. Die erste Optikeinrichtung 4 kann durch Verfahren der Aufnahmeeinrichtung 3 in X-und Y-Richtung bewegt werden, bis die erste Struktur 14 von dem Strahlengang 12 erfasst wird und im Erfassungsbereich 19 der ersten Optikeinrichtung 4 liegt. Anschließend wird die zweite Optikeinrichtung 7 wie oben beschrieben bewegt, bis die zweite Struktur 15 im Strahlengang 13 und einem korrespondierenden Erfassungsbereich 19' (field of view) angeordnet ist.

Eine Bewegung in Z-Richtung erfolgt durch Bewegung der Aufnahmeeinrichtung 3 zur Einstellung eines möglichst geringen, insbesondere einheitlichen (fluchtende Ausrichtung der Stirnseite 4s mit einer Stirnseite 7s der zweiten Optikeinrichtung 7), Abstands der Optikeinrichtungen 4, 7 zu den Strukturen 14, 15 bei der Erfassung der Strukturen 14, 15. Das Verfahren in z-Richtung dient der Einstellung des Fokus und/oder des Arbeitsabstandes, Dem Fachmann auf dem Gebiet ist dieser Abstand unter dem englischen Fachbegriff "working distance" bekannt.

Die Betätigung der Optikeinrichtungen 4, 7, der Erfassungseinrichtung 2 und der Aufnahmeeinrichtung 3 oder der Substrataufnahme erfolgt über nicht dargestellte Antriebsmittel, gesteuert durch die Steuerungseinrichtung.

Die zweite Optikeinrichtung 7 ist gegenüber der ersten Optikeinrichtung 4 fixierbar, sobald die oben beschriebenen Positionen erreicht sind.

Die Linsen 6, 9 der ersten und zweiten Optikeinrichtungen 4, 7 sind vorzugsweise mit sechs Freiheitsgraden versehen, um eine Fokussierung und genaue Einstellung/Kalibrierung der Strahlengänge 12, 13 in Richtung der Prismen 5, 8 zu ermöglichten.

Die Strahlengänge 12, 13 verlaufen parallel zueinander und orthogonal zur Substratoberfläche 16o bis zu den Prismen 5, 8. Während der Strahlengang 12 durch das Prisma 5 ohne Richtungsänderung in den Strahlengang 10 übergeht, erfährt der Strahlengang 13 eine Richtungsänderung in Richtung des Strahlengangs 12 in Form des durch das Prisma 8 (oder Spiegel) umgelenkten Strahlengangs 11. Die Umlenkung erfolgt vorzugsweise exakt orthogonal zum Strahlengang 13.

Der umgelenkte Strahlengang 11 trifft im Bereich des Austritts des Strahlengangs 12 aus dem Prisma 5 beziehungsweise dem Übergang des Strahlengangs 12 zum Strahlengang 10 auf das Prisma 5 und wird dort so abgelenkt, dass der Strahlengang 11 mit dem Strahlengang 12 in den Strahlengang 10 zusammenläuft, und zwar in Richtung der Erfassungseinrichtung 2. Der Strahlengang 10 ist vorzugsweise orthogonal zum Strahlengang 11.

Auf diese Weise kann die Struktur 14 und die Struktur 15 auf der Erfassungseinrichtung 2 zu einem überlagerten Bild zusammengeführt und ausgewertet werden. Die Auswertung erfolgt durch eine, insbesondere in die Erfassungseinrichtung 2 integrierte oder in der - mit der Erfassungseinrichtung logisch verbundene - Steuerungseinrichtung.

Auf entsprechende Weise kann eine Vielzahl von Erfassungspaaren 18 entlang der Substratoberfläche 16o erfasst werden und die jeweiligen, relativen Abstände der korrespondierenden ersten und zweiten Strukturen 14, 15 zu den jeweiligen Erfassungspaaren und deren Position auf der Substratoberfläche 16o gespeichert werden.

Anschließend kann das Substrat 16 einen oder mehrere Behandlungsschritte durchlaufen, die möglicherweise zu einer Formänderung des Substrats 16, insbesondere in X- und Y-Richtung führen. Hierbei spricht man von Dehnungen/Verzerrungen.

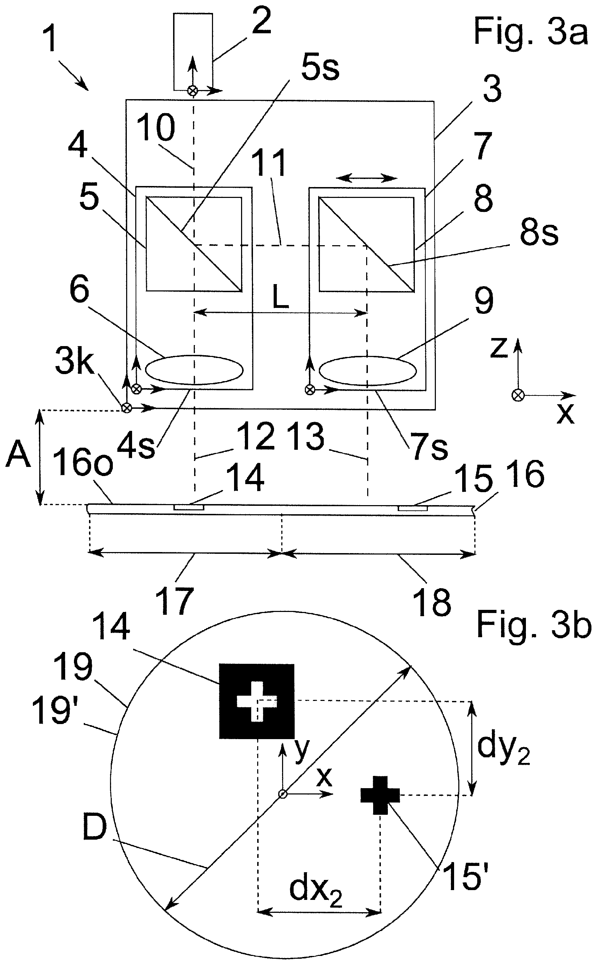

In dem in den Figuren 3a und 3b gezeigten Verfahrensschritt werden entsprechend der oben beschriebenen Erfassung der Abstände dx₁ und dy₁ die möglicherweise geänderten Abstände dx₂ und dy₂ der gespeicherten Erfassungspaare 18 ermittelt. Dabei ist es nicht zwingend erforderlich, dass die erste Optikeinrichtung 4 oder die zweite Optikeinrichtung 7 gegenüber der ersten Struktur 14 oder der zweiten Struktur 15 wieder exakt gleich positioniert werden. Es kommt lediglich darauf an, dass die Strukturen 14, 15 von den Optikeinrichtungen 4, 7 im jeweiligen Erfassungsbereich 19, 19' (field of view) erfassbar sind. Entscheidend ist außerdem, dass die Optikeinrichtungen 4, 7 zueinander die gleiche Position einnehmen und die Strahlengänge 12, 13, 11 und 10 identisch verlaufen wie bei der ersten Erfassung gemäß Figuren 2a und 2b zur Erfassung der Abstände dx₁, dy₁.

Nach Erfassung der Abstände dx₂, dy₂ kann die jeweilige Änderung in X-Richtung (δx = dx₂ - dx₁) und in Y-Richtung (δy = dy₂ - dy₁) berechnet werden und aus den berechneten Vektoren kann auf Formänderungen des Substrats 16 entlang der Substratoberfläche 16o rückgeschlossen werden. Hieraus lässt sich durch die Ermittlung mehrerer Abstandsänderungen an mehreren Erfassungspaaren 18 eine Formänderungskarte beziehungsweise Dehnungskarte und/oder Verzerrungskarte des jeweiligen Substrats 16 erstellen. Diese kann für die weitere Behandlung des Substrats 16, insbesondere zur exakten Positionierung und Ausrichtung des Substrats 16 gegenüber anderen Substraten, verwendet werden. So kann die Ausbeute (yield) deutlich erhöht werden.

Die Strukturen 14, 15 befinden sich mit Vorzug im Fokus der Optikeinrichtungen 4, 7, insbesondere die Linsen 6, 9. Die erfindungsgemäße Vorrichtung kann mit optischem Licht, Infrarot- oder Röntgenstrahlung im Reflexions- oder Transmissionsmodus betrieben werden, beschränkt nur durch die Reflexions- und/oder Transmissionseigenschaften des verwendeten Substratmaterials. Die entsprechenden Detektoren und/oder Lichtquellen, die mit der erfindungsgemäßen Optik 1 verwendet werden, können sich daher auf der gleichen Seite oder auf der jeweils gegenüberliegenden Seite des zu vermessenden Systems befinden. Bei der Verwendung von Infrarotstrahlung ist deren Wellenlänge mit Vorzug größer als 1000nm, mit größerem Vorzug größer als 1050nm, mit größtem Vorzug größer als 1700nm und insbesondere kleiner als 10µm. In einer speziellen Ausführungsform kann die Optik Teil eines Konfokalmikroskops sein, im speziellen eines konfokalen Laser-Rastermikroskop. Für spezielle Anwendungen können Laser als Lichtquellen verwendet werden.

Der Abstand A der Aufnahmeeinrichtung 3 beziehungsweise der Optikeinrichtungen 4, 7 von den Stirnseiten 4s, 7s zur Substratoberfläche 16o bei der Erfassung der Strukturen 14, 15 ist vorzugsweise kleiner als der tatsächliche Abstand B zwischen den Strukturen 14, 15. Weiterhin ist der Abstand A kleiner als die Länge L des umgelenkten Strahlengangs 11.

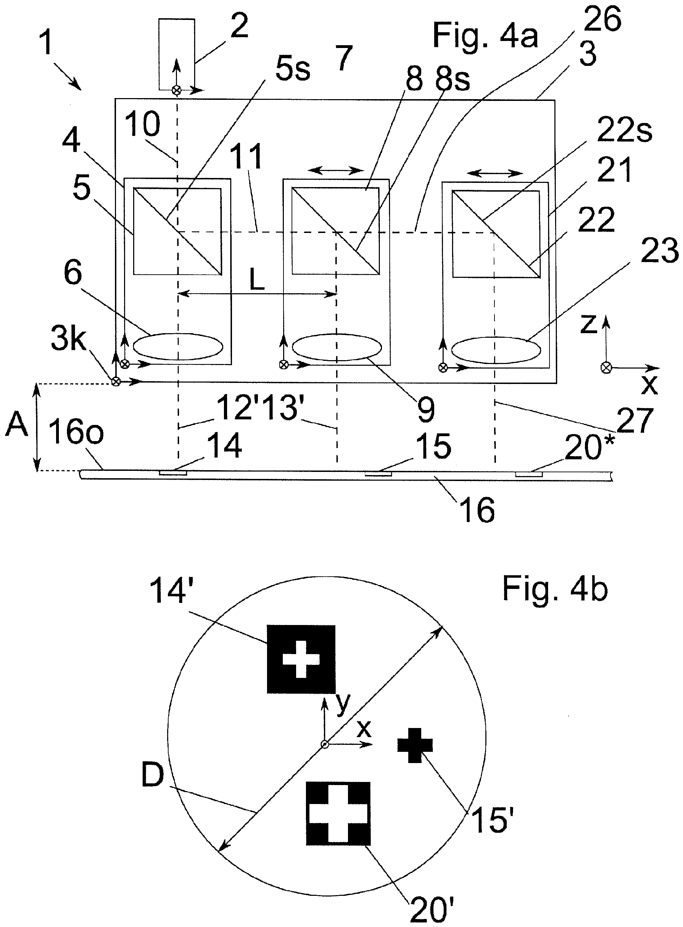

In einer weiteren erfindungsgemäße Ausführungsform gemäß Figuren 4a und 4b, bei der die Optik 1' mehr als zwei (hier: drei) Optikeinrichtungen 4, 7, 21 umfasst, lassen sich in einem Schritt mehrere durch die Optik 1' erzeugten Abbildungen von 14', 15', 20' Strukturen 14, 14, 20 in der Erfassungseinrichtung 2 gleichzeitig erfassen und deren Abstände beziehungsweise Abstandsänderungen schneller ermitteln.

Die Funktion der dritten Optikeinrichtung 21 mit einer Linse 23 und einem Prisma 22 (oder Spiegel) mit einer Schrägfläche 22s zur Umlenkung eines Strahlengangs 27 in einen Strahlengang 26 ist analog der oben zu Figuren 3a, 3b, 4a, 4b beschriebenen zweiten Optikeinrichtung 7, wobei der Strahlengang 26 zumindest teilweise mit dem Strahlengang 11 zusammenfällt, nachdem er durch die Schrägfläche 8s des Prismas 8 zumindest teilweise durchgetreten ist.

Somit ergibt sich das in der Figur 4b gezeigte Bild in der Erfassungseinrichtung 2, in dem die Abbildungen 14', 15' und 20' erfasst sind und, insbesondere von der Steuerungseinrichtung, werden hieraus die Abstände und/oder Abstandsänderungen zwischen den Abbildungen 14', 15' und 20' ermittelt.

In einer weiteren, nicht gezeigten Ausführungsform geht der Strahlengang 10 der (in diesem Fall zentralen) Optikeinrichtung 4 mit Vorzug durch den Schwerpunkt der Optiken, wobei die anderen Optikeinrichtungen der Optik mit Vorzug symmetrisch um die zentrale Optikeinrichtung 4 angeordnet werden. Durch die Verwendung einer solchen n-fach Optik könnten dann insgesamt n Stellen gleichzeitig analysiert werden. Dadurch können durch eine Vorher-/Nachher-Aufnahme auch Korrekturen bezüglich der Rotationsungenauigkeit des Probenhalters in Bezug zur Optik ermittelt und berechnet werden. Danach ist es möglich, durch entsprechende Korrekturmaßnahmen eine Relativrotation zwischen Optik und Probenhalter zu ermöglichen, die mit einem möglichsten kleinen Fehler versehen ist. Es sei auch die Möglichkeit offenbart, besonders bei Systemen mit n-fach Optiken, jede Optik einzeln zu beleuchten.

Die erfindungsgemäße Ausführungsform speichert die überlagerten Bilder vorzugsweise digital, um sie digital zu analysieren und/oder nachzubearbeiten (insbesondere Kontrasterhöhung). Die Verwendung der digital gespeicherten Bilder, deren Auswertung, Aufbereitung zur Steigerung des Auflösungsvermögens durch entsprechende Softwarealgorithmen wird hiermit ebenfalls offenbart.

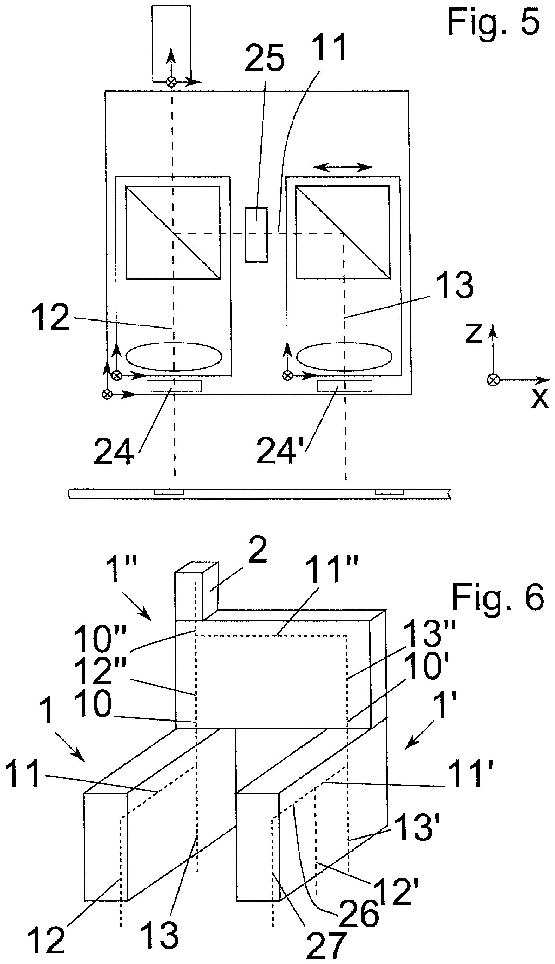

In einer weiteren Ausführungsform der Erfindung gemäß Figur 5, die insbesondere mit den vorbeschriebenen Ausführungsformen kombinierbar ist, sind Filter 24, 24', 25 zur Optimierung der Erfassung vorgesehen. Diese können als Halbschatten- und/oder Polarisationsfilter ausgebildet sein. Beispielsweise kann zur Zuordnung der Abbildungen 14', 15' (und gegebenenfalls 20') zu der korrespondierenden Struktur 14, 15 (und gegebenenfalls 20) ein Filter 24, 24', 25 in den jeweiligen Strahlengang 10, 11, 12, 13 (und gegebenenfalls 26, 27) gefahren werden. Wird der Filter 14 in den Strahlengang 12 eingefahren (oder aktiviert), ist in dem Bild der Erfassungseinrichtung 2 nur noch die Abbildung 15 sichtbar. Die Abbildung 14' wird von dem Filter 14 "geschluckt" und erst wieder sichtbar, sobald der Filter 24 aus dem Strahlengang 12 herausgefahren (oder deaktiviert) wird. Analog gilt dies für die Filter 24' beziehungsweise 25 für die Strahlengänge 13 beziehungsweise 11.

In einer speziellen Ausführungsform können mehrere der erfindungsgemäßen, oben beschriebenen Optiken in einer neuen Ausführungsform kombiniert werden, indem mehrere Optiken 1, 1', 1" hintereinandergeschaltet werden. Dabei werden die überlagerten Strahlengänge 10, 10' der zwei unteren Optiken 1, 1' zu je einem neuen Ausgangsstrahl 12", 13" für die Optik 1" (Fig. 6). Diese ist analog der Optiken 1, 1' aufgebaut, wobei auf Linsen (analog Linsen 6, 9) verzichtet werden kann. Somit werden bei der gezeigten Ausführungsform vier unterschiedliche, insbesondere benachbarte, Erfassungsbereiche 17 erfasst und deren Strukturen 14, 15, 20 (und eine weitere, nicht gezeigte) auf die Erfassungseinrichtung abgebildet. Das Bild ist analog den obigen Ausführungen - gegebenenfalls kombiniert mit Filtern gemäß Figur 5 - auswertbar.

Mit solch einer gestapelten "Mehrfach-Optik" können mehr als zwei Strukturen gleichzeitig erfasst werden.

### Bezugszeichen

- 1, 1', 1": Optik
- 2: Erfassungseinrichtung
- 3: Aufnahmeeinrichtung
- 4: erste Optikeinrichtung
- 5: Prisma
- 5s: Schrägfläche
- 5s: Schrägfläche
- 6: Linse
- 6s: Schrägfläche
- 7: zweite Optikeinrichtung
- 8: Prisma (oder Spiegel)
- 8s: Schrägfläche
- 9: Linse
- 10, 10', 10": Strahlengang
- 11, 11', 11": Strahlengang
- 12, 12', 12": Strahlengang
- 13, 13', 13": Strahlengang
- 14: erste Struktur
- 15: zweite Struktur
- 16: Substrat
- 16o: Substratoberfläche
- 17: Erfassungsfeld
- 18: Erfassungspaar
- 19, 19': Erfassungsbereiche
- 20: weitere Struktur
- 21: weitere Optikeinrichtung
- 22: Prisma (oder Spiegel)
- 22s: Schrägfläche
- 23: Linse
- 24, 24': Filter
- 25: Filter
- 26: Strahlengang
- 27: Strahlengang
- dx1, dy1: erster Abstand
- dx2, dy2: zweiter Abstand
- A: Abstand
- B: Abstand
- D: Durchmessers
- L: Länge

## Patentansprüche

1. Verfahren zur Ermittlung von Formänderungen eines Substrats (16) parallel zu dessen Substratoberfläche (16o), wobei die Formänderungen entlang der Substratoberfläche (16o) auftretende Dehnungen und/oder Verzerrungen sind, die durch eine Behandlung des Substrats (16) verursacht worden sind, mit folgendem Ablauf:
- Ausrichtung einer aus mindestens zwei miteinander verbundenen Optikeinrichtungen (4, 7, 21) bestehenden Optik mit mindestens zwei unterschiedlichen Strahlengängen (10, 11, 12, 13, 25, 27) zur Abbildung von Strukturen (14, 15, 20) auf einer Erfassungseinrichtung (2), wobei die Strahlengängen (10, 11, 12,13) parallel zueinander und orthogonal zur Substratoberfläche (16o) verlaufen,
- Fixierung der mindestens zwei Optikeinrichtungen (4, 7, 21), so dass sich die mindestens zwei Optikeinrichtungen (4, 7, 21) nicht mehr zueinander verschieben,
- Erfassung von Abbildungen (14', 15', 20') der Strukturen (14, 15, 20) mit der Erfassungseinrichtung (2),
- Bildüberlagerung der Abbildungen (14', 15', 20') durch Überlagerung der Strahlengänge (10, 11, 12, 13, 26, 27),
- Ermittlung von Abständen (dx₁, dy₁, dx₂, dy₂, dxₙ, dyₙ) der Abbildungen (14', 15', 20') vor der Behandlung des Substrats (16),
- Behandlung des Substrats (16),
- Erfassung von Abbildungen (14', 15', 20') der Strukturen (14, 15, 20) mit der Erfassungseinrichtung (2) nach der Behandlung des Substrats (16),
- Bildüberlagerung der Abbildungen (14', 15', 20') durch Überlagerung der Strahlengänge (10, 11, 12, 13, 26, 27),
- Ermittlung von Abständen (dx₁, dy₁, dx₂, dy₂, dxₙ, dyₙ) der Abbildungen (14', 15', 20'),
- Ermittlung von Änderungen der Abstände (dx₁, dy₁, dx₂, dy₂, dxₙ, dyₙ) und Durchführung eines Vorher-/Nachher-Vergleichs der Abstände (dx₁, dy₁, dx₂, dy₂, dxₙ, dyₙ).

## Claims

1. A method for determining changes in the shape of a substrate (16) parallel to its substrate surface (16o) with the following progression, wherein the changes of the shape are strains and/or distortions which occur along to the substrate surface (16o):
- alignment of optics consisting of at least two connected optics apparatus (4, 7,21) with at least two different beam paths (10, 11, 12, 13, 26, 27) for imaging of structures (14, 15, 20) on a detection apparatus (2), wherein the beam paths (10, 11, 12, 13) run parallel to one another and orthogonally to the substrate surface (16o),
- fixing the at least two optics apparatus (4,7,21), such that the at least two optics apparatus (4,7, 21) no longer shift to one another,
- detection of images (14', 15', 20') of the structures (14, 15, 20) with the detection apparatus (2),
- superposition of the images (14', 13', 20) by means of superposition of the beam paths (10, 11, 12, 13, 26, 27),
- determination of distances (dx₁, dy₁, dx₂, dy₂, dxₙ, dyₙ) of the images (14', 15', 20) prior to a treatment of the substrate (16),
- treatment of the substrate (16),
- detection of images (14', 15', 20') of the structures (14, 15, 20) with the detection apparatus (2), after the treatment of the substrate (16)
- superposition of the images (14', 15', 20) by means of superposition of the beam paths (10, 11, 12, 13, 26, 27),
- determination of distances (dx₁, dy₁, dx₂, dy₂, dxₙ, dyₙ) of the images (14', 15', 20'),
- determination of changes of the distances (dx₁, dy₁, dx₂, dy₂, dxₙ, dyₙ) and conducting a before/after comparison of the distances (dx₁, dy₁, dx₂, dy₂, dxₙ, dyₙ).

## Revendications

1. Procédé destiné au calcul de modifications de forme d'un substrat (16) parallèlement à sa surface de substrat (16o), dans lequel les modifications de forme sont des dilatations et/ou des distorsions se produisant le long de la surface du substrat (16o), qui ont été provoquées par un traitement du substrat (16), comprenant le déroulement suivant :
- alignement d'une optique composée d'au moins deux dispositifs optiques (4, 7, 21) reliés entre eux comprenant au moins deux trajets de faisceau (10, 11, 12, 13, 26, 27) différents pour représenter des structures (14, 15, 20) sur un dispositif de détection (2), dans lequel les trajets de faisceau (10, 11, 12, 13, 26, 27) sont parallèles entre eux et orthogonaux à la surface de substrat (16o),
- fixation des au moins deux dispositifs optiques (4, 7, 21) de façon à ce que les au moins deux dispositifs optiques (4, 7, 21) ne se décalent plus l'un l'autre,
- détection de représentations (14', 15', 20') des structures (14, 15, 20) avec le dispositif de détection (2),
- superposition d'image des représentations (14', 15', 20') par superposition des trajets de faisceau (10, 11, 12, 13, 26, 27),
- calcul des distances (dx₁, dy₁, dx₂, dy₂, dxₙ, dyₙ) des représentations (14', 15', 20') avant le traitement du substrat (16),
- traitement du substrat (16).
- détection des représentations (14', 15', 20') des structures (14, 15, 20) avec le dispositif de détection (2) après le traitement du substrat (16),
- superposition d'image des représentations (14', 15', 20') par superposition des trajets de faisceau (10, 11, 12, 13, 26, 27),
- calcul des distances (dx₁, dy₁, dx₂, dy₂, dxₙ, dyₙ) des représentations (14', 15', 20'),
- calcul des modifications des distances (dx₁, dy₁, dx₂, dy₂. dxₙ, dyₙ) et exécution d'une comparaison, avant/après des distances (dx₁, dy₁, dx₂, dy₂, dxₙ, dyₙ).
